# EUROPEAN PATENT APPLICATION

(11) **EP 4 675 231 A1**
(43) Date of publication of application: **07.01.2026**
(21) Application number: 25155917.5
(22) Date of filing: 05.02.2025
(51) Int. Cl.: G01D 4/00

(54) **DEVICE AND PROCEDURE FOR REAL TIME MEASUREMENT AND REPORTING OF ENERGY CONSUMPTION**

(71) Applicant: ASTRON d.o.o., 2000 Maribor (SI)
(72) Inventor: Kramberger, Iztok, 2000 Maribor (SI); Pihler, Darko, 2000 Maribor (SI); Novak, Darko, 2000 Maribor (SI)
(74) Representative: Kurig, Thomas

(57) **Abstract**

A device for real-time measurement and reporting of energy consumption is disclosed which comprises a wired interface configured to communicate with an electricity meter 10, retrieve electricity consumption data, and harvest energy for device operation, a wireless interface configured to communicate with automated meter 20, 30, 40 reading infrastructure for receiving data from and not limited to water, gas, and heat meters 20, 30, 40, a wireless mobile network interface configured to synchronize collected energy consumption data with a cloud service, a central processing unit configured to process, store, and synchronize energy consumption data and manage device operations based on energy availability, and an energy management system comprising an intermediate supply capacitor 105 for energy storage and regulation to enable uninterrupted operation of the device.

## Description

### FIELD OF THE INVENTION

The device for real time measurement and reporting of energy consumption collects readings and information from electricity meter using wired consumer/customer (CI) or wired external (P1) meter interface for measurement in reporting of electricity/power consumption and collects readings and information from wireless meter devices for and not limited to water/heat/gas using automated meter reading (AMR) infrastructure (AMI) for measurement and reporting of and not limited to water/heat/gas consumption. The collected measurements and reports of energy consumption from wired and wirelessly attached devices are synchronized/transmitted to cloud service infrastructure using wireless mobile network for analysis of consumption values towards visualization for the end user using any kind of fixed/portable/mobile device capable of presentation of data provided by web internet services. The device is harvesting the energy for its operation from the wired connection of the electricity meter interface. The device includes a central processing unit for data processing purposes, security processing purposes and scheduling purposes, which can be a standalone unit, or an embedded unit in any of the two included wireless connectivity units. The energy needed for the functioning of the device is completely harvested from the wired electricity meter interface, and as such the device does not require any kind of its own energy source. The device can be attached either to a single or a three-phase electricity meter.

### BACKGROUND OF THE INVENTION

The are several existing devices that can perform measurement and reporting of energy consumption data and their synchronization with cloud service infrastructure over mobile networks but are particularly designed either for electricity meter readouts or automated meter reding. To ensure measurement and reporting of whole energy consumption including and not limited to electricity/heat/gas/water and provide those readings to the end user one needs more than one device. Most of the existing devices are either battery or mains powered. The devices powered directly from the mains supply can perform reporting in real time, but they require the availability of external mains power source for their functionality. The battery powered devices are limited by available energy for their functionality and consequently do not reach real time performance but rather limited near real time performance.

Several existing patents and technologies address similar functionalities:
1. Real-Time Energy Consumption Analysis and Reporting: This patent discusses an industrial control architecture that facilitates real-time analysis and reporting of energy consumption data, including water and other resources, within an automation process. https://patents.google.com/patent/US9129231B2/en
2. Systems for Real-Time Analysis and Reporting of Utility Usage and Spend: This invention focuses on non-intrusively collecting and transmitting interval data recording (IDR) sensor data for natural gas, electric, and water utility consumption, enabling users to make real-time determinations of their utility consumption and expenditures. https://patents.google.com/patent/US10460361B2/en
3. Smart Meters as Gateways for Water and Gas Meters: Electricity smart meters are utilized as gateways for gas and water meters, creating integrated smart metering systems. In this configuration, gas and water meters communicate with the electricity meter using Wireless M-Bus (EN 13757-4), a European standard designed for secure and efficient data transmission between utility meters and data collectors. The electricity meter then aggregates this data and transmits it to the central utility network via Power Line Communication (PLC), which leverages existing electrical wiring for data transfer.
   https ://en. wikipedia. org/wiki/Smart_meter

### SUMMARY OF THE INVENTION

Same/single device incorporates wired electricity meter interface for communication with and functional energy harvesting from an attached electricity meter, automated wireless meter reading interface for communication with automated wireless meter infrastructure, and wireless mobile network interface for data communication/synchronization with cloud service infrastructure, procedures included at the level of the device for preprocessing of consumption data to lower the quantity of data traffic towards the cloud, and the procedures at the cloud service to identify possible overloads with reporting towards the user. The electrical power supply of the device provides the energy for its full functionality purely from the attached electricity meter interface based on energy harvesting, where the maximum power consumption of the device at full operation is below 500 milliwatts.

The major advantage is that a single device provides real time measurement and reporting of full energy consumption, which is not only either electricity or not limited to water/heat/gas but joined energy consumption data. Real time reporting of energy consumption data is achieved using energy harvesting for its functioning from the attached electricity meter, and as such the device can operate continuously without interruption. The connectivity with cloud service using mobile networks does not require any involvement of the user not during installation and not during usage. The procedures to preprocess the consumption data at the level of the device minimize the costs associated with data traffic towards the cloud service by minimizing the quantity of data being transferred to the cloud service. The procedures at the cloud service using cloud-based predictive analysis of real time consumption data can predict possible overloads or assessment of energy consumption according to energy source, forecasting peak usage times using machine learning algorithms, perform real-time adjustments to device operation schedules, and dynamic recommendations for energy-saving measures.

The object of the invention is achieved by a device for real-time measurement and reporting of energy consumption, comprising a wired interface configured to communicate with an electricity meter, retrieve electricity consumption data, and harvest energy for device operation, a wireless interface configured to communicate with automated meter reading infrastructure for receiving data from and not limited to water, gas, and heat meters, a wireless mobile network interface configured to synchronize collected energy consumption data with a cloud service, a central processing unit configured to process, store, and synchronize energy consumption data and manage device operations based on energy availability, and an energy management system comprising an intermediate supply capacitor for energy storage and regulation to enable uninterrupted operation of the device.

It is preferred that the wired interface is compliant with M-bus (EN 13757) or IEC 62056 standards and includes functionality for secure data transmission.

It is preferred that the wireless mobile network interface supports Long-Term Evolution (LTE-M), LTE-Narrowband IoT (LTE NB-IoT), or LTE Category 1bis standards for efficient data communication.

It is preferred that the wireless interface for automated meter reading infrastructure operates in the ISM band and complies with Wireless M-Bus (EN 13757-4) standards in S, T, or C modes.

It is preferred that the central processing unit executes a local data handling procedure to preprocess consumption data to reduce data traffic to the cloud, to monitor voltage levels in the energy management system, and to synchronize device operations with the remote cloud service.

It is preferred that the energy management system further includes a voltage supervisory circuit to monitor the charge state of the intermediate supply capacitor, and a watchdog timer to prevent device malfunction during operation.

It is preferred that the cloud service performs synchronization of operational parameters for the device, prediction of possible energy overloads, and storage and visualization of real-time and historical energy consumption data.

It is preferred that the energy harvested from the wired electricity meter interface is sufficient to maintain the device's functionality without any external power source or battery.

The object of the invention is further achieved by a method for real-time measurement and reporting of energy consumption, comprising the steps of retrieving consumption data from an electricity meter via a wired interface while harvesting energy for device operation, receiving consumption data from and not limited to water, gas, and heat meters via a wireless interface, synchronizing consumption data with a cloud service using a wireless mobile network interface, preprocessing consumption data at the device level to reduce the quantity of data transmitted to the cloud service, and visualizing consumption data for end users through web-based interfaces or mobile devices.

### BRIEF DESCRIPTION OF THE DRAWINGS

Figure 1 shows the device for real time measurement and reporting of energy consumption and system level overview.
Figure 2 shows an overview of the interface for electricity meters 10 with power management.

### DETAILED DESCRIPTION OF THE INVENTION

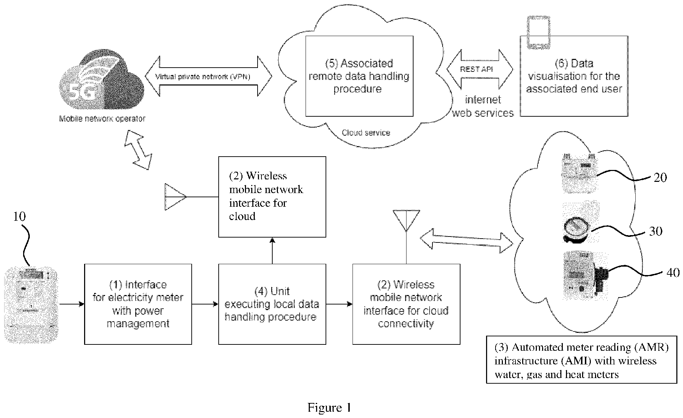

Figure 1 shows the device for real time measurement and reporting of energy consumption and system level overview. The device for real time measurement and reporting of energy consumption consists of six main elements:
interface for smart electricity meter 10 with power management (1),
wireless mobile network interface for cloud connectivity (2),
wireless interface for automated meter reading infrastructure connectivity (3),
unit executing local data handling procedure 108 at the device level (4),
associated remote data handling procedure executed at the cloud service level (5), and
data visualization for the associated end user using any kind of fixed/portable/mobile device capable of presentation of data provided by the internet web services (6).

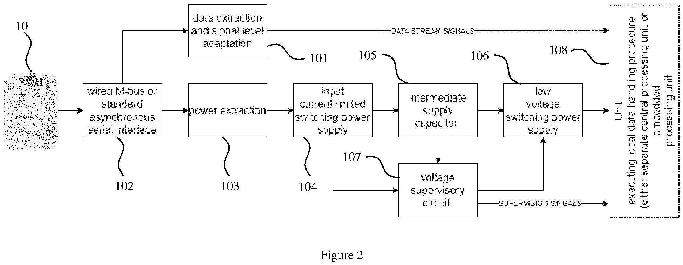

Figure 2 shows an overview of the interface for electricity meters 10 with power management.
(1) The interface for electricity meters 10 with power management serves as the main interface for electricity meter 10 data readout including energy harvesting for device operation. The electricity meter 10 data readout at the physical layer (data extraction and signal level adaptation 101) is implemented either via wired M-bus (EN 13757) or standard asynchronous serial interface 102, both including capability of delivering remote powering of a slave device (power extraction 103) in compliance with set of standards IEC 62056. The power management part of the electricity meter 10 interface includes an input current limited switching power supply 104 that harvests the remote power from the electricity meter 10 and continuously charges the intermediate supply capacitor 105 while limiting the charge current to a maximum available value defined by the connectivity standard. The intermediate supply capacitor 105 serves as an energy buffer between the limited but continuous energy available from the remote power provided by the electricity meter 10 and the actual non-constant supply power required for device operation. The non-constant nature of the power supply for device operation is because the device can be in different states of operation with different power requirements. Specifically, during transmission intervals of wireless interfaces the power consumption of the device is higher that during reception and general data handling operations. The intermediate supply capacitor 105 is charged to a higher voltage that required for normal device operation because the energy stored in the intermediate supply capacitor 105 is proportional to the square of charging voltage. To ensure the supply voltage needed and being applicable by the remaining device components the second low voltage switching power supply 106 is implemented that uses the intermediate supply capacitor 105 as its primary power source and regulates its output to the voltages needed by the rest of the device components. In addition, a voltage supervisory circuit 107 is added to the power management of the device that continuously monitors the state of charge of the intermediate supply capacitor 105 by means of low and high voltage threshold and reports the state to the central processing unit to decide if device can enter specific operation modes like wireless transmission. The voltage supervisory circuit 107 also controls the general reset signal of the device to ensure that device does not enter an undesirable operating state due to undervoltage conditions. Furthermore, the voltage supervisory circuit 107 also acts as a watchdog timer supervising the correct execution of local data handling procedure at the device level. In addition, the voltage supervisory circuit 107 also monitors the voltage present at the input of the current limited switching power supply to detect input power failure by monitoring the presence of the voltage provided at the electricity meter 10 interface, which can occur either at loss of mains voltage at the electricity meter 10 or manual device detachment from the interface for electricity meter 10. In both cases the device can detect the loss of mains voltage in real time as there is enough energy stored in the intermediate supply capacitor 105 to report such failure either as loss of mains voltage or fraud. The interface for electricity meter 10 with power management performs all needed operations at the physical layer, data link layer, transport layer and session layer of the wired electricity meter 10 interface to ensure successful retrieval of all the electricity consumption/production data provided by the meter 10. The consumption/production data provided by the electricity meter 10 can vary depending on its configuration and type, wherein the device distinguishes between produced or renewable (e.g., solar, wind) and consumed or non-renewable energy consumption data and generates separate reports for each source.
(2) Wireless mobile network interface for cloud connectivity is implemented using a unit providing wireless connectivity to cellular low-power wide-area network (LPWA) networks compliant with either Long-Term Evolution Machine Type Communication (LTE-M) mobile networks or Long-Term Evolution Narrowband Internet of things (LTE NB-IoT) mobile networks or new variant of the medium speed wireless communication standard Long-Term Evolution Category 1bis (LTE Cat-1bis) requiring only single antenna. Unit embeds a subscriber identity module (SIM) required to securely store an international mobile subscriber identity (IMSI) number and its related key used to identify and authenticate the device during mobile network attachment. Attachment and detachment to and from the mobile network is controlled by the local data handling procedure considering the signaling from the voltage supervisory circuit 107 of interface for electricity meter 10 with power management by monitoring the state of charge of the intermediate supply capacitor 105. At the attachment of the unit to the mobile network the communication between the device and the cloud service is established using Message Queuing Telemetry Transport (MQTT) protocol over the Transmission Control Protocol/Internet Protocol. The unit performs all needed operations at the physical layer, data link layer, network layer, transportation layer, and session layer of the wireless mobile network to ensure data exchange between the local data handling procedure and the associated remote data handling procedure.
(3) Wireless interface for automated meter 20, 30, 40 reading infrastructure connectivity is implemented using a unit providing wireless connectivity to long range wireless sensor networks (IEC 61107) compliant with Wireless M-Bus (EN 13757-4) operating in the license-free ISM bands. Unit can operate in S, T, and C mode as defined by EN 13757 standard. Unit can receive or transmit data wirelessly between the device and the sensors within the radio signal range in S, T, and C modes according to the Wireless M-Bus standard. The mode of operation is controlled by the local data handling procedure considering the parametrization provided by the associated remote data handling procedure at the cloud service. Unit can be configured to different states of operation including continuously receive or listed for data packets transmitted by the sensors, or to transmit data packets from the device to the sensors or be put in low power mode by turning off the radio receiver and the radio transmitter. The state of operation is controlled by the local data handling procedure considering parametrization provided by the associated remote data handling procedure at the cloud service. Parametrization of the local data handling procedure includes local schedule, which is driven by the local real time clock, and provides time-based control of the mode and state of operation of the unit. The real time clock and schedule are synchronized with the associated remote data handling procedure at the cloud service. In this way the associated remote data handling procedure at cloud service can control when, for how long and in which mode the device is communicating with wireless sensor network. The unit performs all needed operations at the physical layer, data link layer, network layer, transport layer, and session layer of the wireless interface for automated meter 20, 30, 40 reading to ensure reception of data packets transmitted by the sensors and transmission of data packets to the sensors.
(4) Unit executing local data handling procedure 108 at the device level can be either a separate central processing unit implemented at the device or an embedded processing unit within the wireless mobile network interface unit in form of Embedded Attention (EAT). Unit executes the local data handling procedure in the form of software, which is remotely upgradable via associated remote data handling procedure executed at the cloud service. Unit includes functions listed below:
   a. Monitors the signals provided by the voltage supervisory circuit 107 to determine if there is enough energy harvested from the electricity meter 10 and stored in the intermediate supply capacitor 105 to engage the mobile network attachment.
   b. Performs attachment of the wireless mobile network interface to the mobile network by establishing a virtual private channel (VPN) to secure the communication channel using credentials provided on the embedded subscriber identity module (SIM).
   c. Performs reset or detachment of the wireless mobile network interface from the mobile network in case the energy stored in the intermediate supply capacitor 105 is not sufficient for further operation.
   d. If attachment to the mobile network is successful, it performs establishment of TCP/IP communication with the associated remote data handling procedure and creates a communication channel using MQTT protocol.
   e. Identifies the device using international mobile equipment identity (IMEI) as unique identifier provided by the wireless mobile network interface producer.
   f. Performs synchronization of operational parameters with the associated remote data handling procedure.
   g. Performs reception of consumption data provided by the electricity meter 10 using electricity meter 10 data readout, thus including:
      i. load profile as variation in the electrical load versus time with accumulated absolute energy consumed and produced, where the interval time of load recording can be set in the range from 1 minute to 60 minutes, and the default interval time is 15 minutes,
      ii. rolling data recordings of power parameters (consumed active power, produced active power, reactive power, power factor, voltages, currents), where the interval time of rolling data recording can be set in seconds, and the default interval time is 5 seconds.
   h. Performs decryption of the consumption data provided by the electricity meter 10 using stored key in embedded secure element if the data is encrypted.
   i. Performs synchronization of the electricity meter 10 security key for decryption of electricity meter 10 consumption data with the associated remote data handling procedure if new key is provided at the cloud service and stores the key in the embedded secure element to protect the key against high-level software and hardware attacks.
   j. Performs synchronization of gathered consumption data with the associated remote data handling procedure to reflect consumption data at the cloud service.
   k. Performs delta calculations of rolled consumed and produced power values provided by the electricity meter 10 by calculating the difference to previously received values, and compares calculated delta to adjustable threshold:
      i. if consumed or produced calculated delta power is greater than the adjustable parameter, the new delta power is published to the remote data handling procedure to reflect new delta power at the cloud service
      ii. the delta calculations of rolled consumed and produced power values provided by the electricity meter 10 provide real time observation of the current power at the cloud service while lowering the amount of data transmitted via wireless mobile network interface as not each rolled data is transmitted but only those having reasonable before adjusted power change threshold.
   l. Performs monitoring of fluctuations of the mains voltage or voltages regarding the compliance with maximum allowable fluctuations of ± 10%, which is calculated from the rolling data of the electricity meter 10. In case of noncompliance with maximum allowable fluctuation of the mains voltage, the event is published to the remote data handling procedure to reflect it at the associated remote data handling procedure for user notification.
   m. Performs monitoring of the mains current, or currents provided by the rolling data from the electricity meter 10 regarding the overload at the level of 40% over the rated disconnector (fuse) current for the time interval of 90 seconds to detect tripping of the disconnector, which is integrated within the electricity meter 10. In case of tripping the disconnector (fuse), the event is published to the remote data handling procedure to reflect it at the associated remote data handling procedure for user notification.
   n. Performs adjustment of the wireless interface for automated meter 20, 30, 40 reading by setting its state and mode of operation, thus including synchronization of the schedule for operation with the associated remote data handling procedure.
   o. Monitors the presence of the of device's supply voltage at the electricity meter 10 to detect mains supply failure at the electricity meter 10 or fraud detachment of the device from the electricity meter 10, where in both cases the failure is reported to the associated remote data handling procedure to reflect such a state at the cloud service for user notification.
   p. Performs decoding of received data the wireless interface for automated meter 20, 30, 40 reading.
   q. Performs filtering of received data the wireless interface for automated meter 20, 30, 40 reading by data identifier using adjustable filter with multiple entries:
      i. if data identifier filter is set, the device can filter the received data according to the filter entries to ensure accumulation of and not limited to water, gas and heat meters 20, 30, 40 consumption values that are associated with the final user.
      ii. during installation procedure the data identifier filter is cleared to ensure all received data is synchronized with the associated remote data handling procedure to ensure all meters 20, 30, 40 are identified, while after the installation procedure is completed, the filter is adjusted with entries that are associated with the device.
   r. Performs synchronization of collected consumption data for and not limited to gas, water and heat provided by the wireless meter 20, 30, 40 infrastructure via wireless interface for automated meter 20, 30, 40 reading with the associated remote data handling procedure to reflect the consumption data for and not limited to water, gas and heat at the cloud service.
(5) Unit executing associated remote data handling procedure at the cloud service level includes functions listed below:
   a. Performs identification of the device using unique international mobile equipment identity (IMEI).
   b. Performs synchronization of operational parameters with the associated remote data handling procedure, thus including:
      i. key management for decryption of electricity meter 10 consumption data at the device level.
      ii. delta power change threshold used by calculations of rolled consumed and produced power values.
      iii. state and mode of operation for wireless interface for automated meter 20, 30, 40 reading including schedule and filter parameters.
   c. Performs calculations of average consumed or produced power from received load profiles provided by the device.
   d. Performs billing calculations of average consumed or produced power from received load profiles related to the exceeded power according to the agreed power and billing period.
   e. Performs prediction calculations of consumed or produced power from the delta power values provided by the device to estimate the consumed or produced predicted average power regarding the adjustable billing interval and adjustable accounting period.
   f. Performs storage of accumulated consumed and produced electrical energy in the database.
   g. Performs storage of current consumed and produced electrical power calculated from the received load profiles with associated time stamps in the database.
   h. Performs storage of current consumed and produced electrical power obtained by the received delta power with associated time stamps in the database.
   i. Performs monitoring of mains supply failure event at the electricity meter 10 or fraud detachment of the device from the electricity meter 10 to notify the associated user with applicable push notification.
   j. Performs monitoring of voltage fluctuations compliance event to notify the associated user with applicable push notification.
   k. Performs monitoring of overload of disconnector (fuse) tripping event to notify the associated user with applicable push notification.
   l. Perform storage of consumption data for and not limited to water, gas and heat obtained by the received automated meter 20, 30, 40 readings with associated time stamps in the database.
   m. Provides representational state transfer (REST) application interface (API) for data visualization for the end user, thus including:
      i. visualization of real time consumption data for and not limited to electricity, water, gas and heat.
      ii. visualization of consumption data history for and not limited to electricity, water, gas and heat.
      iii. visualization of billing information for the last billing interval.
      iv. adjustment of billing periods.
      v. adjustment of agreed power per billing period.
      vi. prediction of possible exceeding of the agreed power per billing period.
      vii. push notifications of warnings and alarms in cases of exceeded power regarding agreed power, mains supply failure at the electricity meter 10 or fraud detachment of the device from the electricity meter 10, noncompliance with maximum allowable fluctuation of the mains voltage, and tripping the integrated electricity meter 10 disconnector (fuse).
   n. Provides representational state transfer (REST) application interface (API) for system administrators, thus including:
      i. adjustment of delta power change threshold.
      ii. adjustment of state and mode of operation for wireless interface for automated meter 20, 30, 40 reading including schedule and filter parameters.
      iii. security key management for electricity meter 10 interface.
      iv. data management regarding storage of data within the database.
(6) Unit for data visualization for the end user can be using any kind of fixed / portable / mobile device capable of presentation of data provided by web internet services. Unit communicates exclusively with the unit executing associated remote data handling procedure using representational state transfer (REST) application interface (API) and needs to be identified and authenticated prior to any communication via world wide web. Users must register themselves by creating an account and associate their device or devices by scanning QR code provided on the device or devices. When unit for data visualization is attached to the associated remote data handling procedure it becomes associated with the authenticated user and as such capable of data visualization provided by the representational state transfer (REST) application interface (API), thus including push notifications, wherein user authentication is implemented using biometric verification or multi-factor authentication to access energy consumption data.

## Claims

1. A device for real-time measurement and reporting of energy consumption, comprising:
a wired interface which is configured to communicate with an electricity meter (10) for retrieving electricity consumption data, and to harvest energy for device operation;
a first wireless connectivity unit including a wireless interface which is configured to communicate with automated meter (20, 30, 40) reading infrastructure for receiving energy consumption data from and not limited to water, gas, and heat meters (20, 30, 40); and
a second wireless connectivity unit including a wireless mobile network interface which is configured to synchronize collected electricity consumption data from the electricity meter (10) and the energy consumption data from and not limited to the water, gas and heat meters (20, 30, 40) with a cloud service;
wherein a central processing unit which is a standalone unit or an embedded unit in any of the two wireless connectivity units is configured to process, store, and synchronize the electricity consumption data from the electricity meter (10) and the energy consumption data from and not limited to the water, gas and heat meters (20, 30, 40) and to manage the device operations based on the availability of the energy which is harvested;
wherein the energy harvested by the wired interface is managed by an energy management system which is included in the device comprising an intermediate supply capacitor 105 for energy storage and regulation to enable uninterrupted operation of the device.

2. The device of claim 1, wherein the wired interface is compliant with M-bus (EN 13757) or IEC 62056 standards and includes functionality for secure data transmission.

3. The device of claim 1, wherein the wireless mobile network interface supports Long-Term Evolution (LTE-M), LTE-Narrowband IoT (LTE NB-IoT), or LTE Category 1bis standards for efficient data communication.

4. The device of claim 1, wherein the wireless interface for automated meter (20, 30, 40) reading infrastructure operates in the ISM band and complies with Wireless M-Bus (EN 13757-4) standards in S, T, or C modes.

5. The device of claim 1, wherein the central processing unit executes a local data handling procedure to:
a. preprocess consumption data to reduce data traffic to the cloud;
b. monitor voltage levels in the energy management system; and
c. synchronize device operations with the remote cloud service.

6. The device of claim 1, wherein the energy management system further includes:
a. a voltage supervisory circuit 107 to monitor the charge state of the intermediate supply capacitor 105; and
b. a watchdog timer to prevent device malfunction during operation.

7. The device of claim 1, wherein the cloud service performs:
a. synchronization of operational parameters for the device;
b. prediction of possible energy overloads; and
c. storage and visualization of real-time and historical energy consumption data.

8. The device of claim 1, wherein the energy harvested from the wired electricity meter (10) interface (1) is sufficient to maintain the device's functionality without any external power source or battery.

9. The device of claim 1, wherein the wireless interface is modularly configurable to support simultaneous data acquisition from multiple automated meter (20, 30, 40) reading (AMR) infrastructures, including and not limited to electricity, gas, water, and heat meters (20, 30, 40), enabling seamless adaptation to varying utility requirements.

10. The device of claim 1, wherein the energy management system dynamically adjusts energy harvesting efficiency by monitoring real-time power availability from the electricity meter (10) and optimizing energy distribution based on the device's operational demands.

11. The device of claim 1, further comprising a fraud detection mechanism configured to monitor the physical connection to the electricity meter (10), detect unauthorized detachment or tampering, and report such events to the cloud service for user notification.

12. The device of claim 1, wherein all data transmissions to and from the device are secured using end-to-end encryption protocols, incorporating secure key exchanges via an embedded cryptographic module for enhanced data protection.

13. The device of claim 1, wherein collected energy consumption data is integrated with smart home systems to enable adaptive control of appliances, such as HVAC systems and smart lighting, for improved energy efficiency and cost savings.

14. The device of claim 1, wherein energy consumption data from renewable sources, such as solar panels or wind turbines, is processed alongside utility data to provide comprehensive insights on energy self-sufficiency and environmental impact.

15. The device of claim 1, wherein user authentication is implemented through multi-factor authentication or biometric verification, ensuring secure access to energy consumption data and system controls.

16. A method for real-time measurement and reporting of energy consumption, comprising the steps of:
a. retrieving consumption data from an electricity meter (10) via a wired interface while harvesting energy for device operation;
b. receiving consumption data from and not limited to water, gas, and heat meters (20, 30, 40) via a wireless interface;
c. synchronizing consumption data with a cloud service using a wireless mobile network interface;
d. preprocessing consumption data at the device level to reduce the quantity of data transmitted to the cloud service; and
e. visualizing consumption data for end users through web-based interfaces or mobile devices.

17. A method for optimizing energy efficiency during data transmission, comprising:
a. Scheduling data transmission intervals based on the energy availability monitored by the energy management system;
b. Utilizing delta encoding techniques to minimize the size of transmitted data packets; and
c. Employing low-power communication modes for non-critical data synchronization tasks.

18. A method for aggregating energy consumption data from heterogeneous sources, comprising:
a. Retrieving energy consumption data from electricity, gas, water, and heat meters (20, 30, 40) via their respective interfaces;
b. Converting the retrieved data into a standardized format for unified processing; and
c. Synchronizing the aggregated data with a cloud-based service for comprehensive user visualization and analysis.

19. A method for notifying users of critical energy-related events, comprising:
a. Monitoring consumption thresholds and operational parameters at the cloud service level;
b. Generating alerts for events such as voltage fluctuations, power overloads, or tampering with the device; and
c. Delivering notifications to registered user devices through push notifications, SMS, or email.

20. A system for distributed energy data processing, wherein:
a. The device's central processing unit performs preprocessing of raw data locally to reduce transmission bandwidth; and
b. The cloud service executes advanced analytics, including trend prediction, energy efficiency modeling, and anomaly detection, for enhanced user insights.

21. A system for managing energy sources, wherein the device distinguishes between renewable energy sources, such as solar or wind, and conventional sources, such as grid electricity, and generates detailed, source-specific consumption reports.

22. A system for cloud-based predictive analytics, comprising:
a. Machine learning algorithms configured to forecast peak energy consumption periods based on historical and real-time data;
b. Dynamic adjustments to the device's operational schedule to reduce energy costs; and
c. Recommendations for users to implement energy-saving measures based on predictive insights.

## Amended claims

### Amended claims in accordance with Rule 137(2) EPC.

1. A device for real-time measurement and reporting of energy consumption, comprising:
a wired interface which is configured to communicate with an electricity meter (10) for retrieving electricity consumption data, and to harvest energy for device operation;
a first wireless connectivity unit including a wireless interface which is configured to communicate with automated meter (20, 30, 40) reading infrastructure for receiving energy consumption data from and not limited to water, gas, and heat meters (20, 30, 40); and
a second wireless connectivity unit including a wireless mobile network interface which is configured to synchronize collected electricity consumption data from the electricity meter (10) and the energy consumption data from and not limited to the water, gas and heat meters (20, 30, 40) with a cloud service;
wherein a central processing unit which is a standalone unit or an embedded unit in any of the two wireless connectivity units is configured to process, store, and synchronize the electricity consumption data from the electricity meter (10) and the energy consumption data from and not limited to the water, gas and heat meters (20, 30, 40) and to manage the device operations based on the availability of the energy which is harvested;
wherein the energy harvested by the wired interface is managed by an energy management system which is included in the device comprising an intermediate supply capacitor 105 for energy storage and regulation to enable uninterrupted operation of the device.

2. The device of claim 1, wherein the wired interface is compliant with M-bus (EN 13757) or IEC 62056 standards and includes functionality for secure data transmission.

3. The device of claim 1, wherein the wireless mobile network interface supports Long-Term Evolution (LTE-M), LTE-Narrowband IoT (LTE NB-IoT), or LTE Category 1bis standards for efficient data communication.

4. The device of claim 1, wherein the wireless interface for automated meter (20, 30, 40) reading infrastructure operates in the ISM band and complies with Wireless M-Bus (EN 13757-4) standards in S, T, or C modes.

5. The device of claim 1, wherein the central processing unit executes a local data handling procedure to:
a. preprocess consumption data to reduce data traffic to the cloud;
b. monitor voltage levels in the energy management system; and
c. synchronize device operations with the remote cloud service.

6. The device of claim 1, wherein the energy management system further includes:
a. a voltage supervisory circuit 107 to monitor the charge state of the intermediate supply capacitor 105; and
b. a watchdog timer to prevent device malfunction during operation.

7. The device of claim 1, wherein the cloud service performs:
a. synchronization of operational parameters for the device;
b. prediction of possible energy overloads; and
c. storage and visualization of real-time and historical energy consumption data.

8. The device of claim 1, wherein the energy harvested from the wired electricity meter (10) interface (1) is sufficient to maintain the device's functionality without any external power source or battery.

9. The device of claim 1, wherein the wireless interface is modularly configurable to support simultaneous data acquisition from multiple automated meter (20, 30, 40) reading (AMR) infrastructures, including and not limited to electricity, gas, water, and heat meters (20, 30, 40), enabling seamless adaptation to varying utility requirements.

10. The device of claim 1, wherein the energy management system dynamically adjusts energy harvesting efficiency by monitoring real-time power availability from the electricity meter (10) and optimizing energy distribution based on the device's operational demands.

11. The device of claim 1, further comprising a fraud detection mechanism configured to monitor the physical connection to the electricity meter (10), detect unauthorized detachment or tampering, and report such events to the cloud service for user notification.

12. The device of claim 1, wherein all data transmissions to and from the device are secured using end-to-end encryption protocols, incorporating secure key exchanges via an embedded cryptographic module for enhanced data protection.

13. The device of claim 1, wherein collected energy consumption data is integrated with smart home systems to enable adaptive control of appliances, such as HVAC systems and smart lighting, for improved energy efficiency and cost savings.

14. The device of claim 1, wherein energy consumption data from renewable sources, such as solar panels or wind turbines, is processed alongside utility data to provide comprehensive insights on energy self-sufficiency and environmental impact.

15. The device of claim 1, wherein user authentication is implemented through multi-factor authentication or biometric verification, ensuring secure access to energy consumption data and system controls.

16. A method for operating a device according to claim 1, comprising the steps of:
a. retrieving consumption data from an electricity meter (10) via a wired interface while harvesting energy for device operation;
b. receiving consumption data from and not limited to water, gas, and heat meters (20, 30, 40) via a wireless interface;
c. synchronizing consumption data with a cloud service using a wireless mobile network interface;
d. preprocessing consumption data at the device level to reduce the quantity of data transmitted to the cloud service; and
e. visualizing consumption data for end users through web-based interfaces or mobile devices.
